# EUROPEAN PATENT APPLICATION

(11) **EP 4 610 666 A1**
(43) Date of publication of application: **03.09.2025**
(21) Application number: 25160246.2
(22) Date of filing: 26.02.2025
(51) Int. Cl.: G01R 1/04, G01R 15/18

(54) **MEASUREMENT SENSOR**

(30) Priority: 29.02.2024 GB 202402914
(71) Applicant: GMC-I Prosys Ltd., Lancashire WN8 9PH (GB)
(72) Inventor: GOULDSON, Dean, Skelmersdale, WN8 9PH (GB)
(74) Representative: Marks & Clerk LLP

(57) **Abstract**

There is provided a measurement sensor 2. The measurement sensor 2 comprises a housing 4, and a cable 6 having a first end 8 that extends from the housing 4 and a free second end 10. The housing 4 comprises at least one resilient finger 16, and a socket 18 that is defined, at least in part, by the at least one resilient finger 16. The socket 18 defines a central axis 20. The free second end 10 of the cable 6 is receivable by the socket 18 such that the at least one resilient finger 16 engages the free second end of the cable 6 to releasably retain the free second end 10 of the cable 6 within the socket 18. The measurement sensor 2 further comprises a locking member 12 that is mounted to the housing 4. The locking member 12 is moveable between an unlocked configuration and a locked configuration. In the locked configuration, the locking member 12 limits deformation of the at least one resilient finger 16.

## Description

### Field of Invention

The present invention relates to a measurement sensor and to a locking member for a measurement sensor

### Background

Numerous types of measurement sensors exist. One type of measurement sensor is a Rogowski coil, which are used to measure alternating current, or high speed current pulses. A Rogowski coil sensor comprises a housing and a cable. A first end of the cable extends from the housing, and a second free end of the cable is releasably coupleable to the housing. In use, the cable is wrapped around a conductor, such as a wire, and the second free end is coupled to the housing.

The present invention seeks to address one or more issues associated with the prior art, whether identified herein or otherwise.

### Summary of Invention

In a first aspect of the invention there is provided a measurement sensor. The measurement sensor comprises a housing, and a cable having a first end that extends from the housing and a free second end. The housing comprises at least one resilient finger, and a socket that is defined, at least in part, by the at least one resilient finger. The socket defines a central axis. The free second end of the cable is receivable by the socket such that the at least one resilient finger engages the free second end of the cable to releasably retain the free second end of the cable within the socket. The measurement sensor further comprises a locking member that is mounted to the housing. The locking member is moveable between an unlocked configuration and a locked configuration. In the locked configuration, the locking member limits deformation of the at least one resilient finger.

The measurement sensor may be for measuring electrical current. The electrical current measurable by the sensor may be alternating and/or or direct current and/or high speed electrical current pulses.

The cable may be referred to as a coil or rope.

At least one resilient finger may extend from the housing.

When the free second end of the cable is received by the socket, at least one resilient finger may releasably retain the free second end of the cable within the socket.

The unlocked configuration may be referred to as a first configuration, or as a disengaged configuration. When the locking member is in the unlocked configuration, the one or more resilient members may be deformable to permit the release of the free second end of the cable from the socket. In the unlocked configuration, the free second end of the cable may be insertable into the socket. In the locked configuration, the locking member may limit deformation of the at least one finger to retain the free second end of the cable in the socket.

Limiting deformation of the at least one resilient finger may inhibit release of the free second end of the cable from the socket.

The locking member may be disposed about the at least one resilient finger. The locking member may limit radial deformation of the at least one resilient finger.

The one or more resilient finger and locking member provide, in combination, a dual locking arrangement whereby both the at least one resilient finger and the locking member act to secure the free second end of the cable within the socket. This advantageously reduces the likelihood of the free second end being inadvertently withdrawn from the socket in use. This is as compared to if, for example, only one of the at least one resilient finger or the locking member were provided.

The locking member may comprise at least one radially inward protrusion. The at least one radially inward protrusion may limit radially outward deformation of the at least one resilient finger when the locking member is in the locked configuration.

The locking member may comprise a plurality of radially inward protrusions.

The number of radially inward protrusions may be equal to the number of resilient fingers.

In the unlocked configuration, a radial distance from the central axis to a radially outer surface of the at least one finger may be greater than or equal to a radial distance from the central axis to a radially inner surface of the at least one protrusion.

This advantageously better limits movement of the at least one resilient finger when the locking member is in the locked configuration.

The free second end of the cable may be receivable by the socket such that the at least one resilient finger interlocks with the free second end of the cable.

Where the one or more fingers interlock with the free second end of the cable, the likelihood of the free second end of the cable being inadvertently withdrawn from the socket is advantageously further reduced.

The at least one resilient finger may comprise a radially inward protrusion. The free second end of the wire may comprise a radially outward protrusion. The radially inward protrusion may interlock with the radially outward protrusion when the free second end of the cable is received by the socket.

This is a particularly robust arrangement for reducing the likelihood of inadvertent withdrawal of the free second end of the cable from the socket.

The radially inward protrusion may be disposed at a distal end of the at least one resilient finger.

The term 'distal end' with respect to the at least one resilient finger may be understood to a distal end region, or an absolute distal end.

With the locking member in the unlocked configuration, during insertion of the free second end of the cable, the at least one resilient finger may be configured to deform radially outwardly.

The measurement sensor may further comprise an elastic member that is disposed about the at least one resilient finger. The elastic member may be configured to urge the at least one resilient finger radially inwards.

The elastic member may be disposed about, and engage, an external surface of each of the fingers of the plurality of resilient fingers.

The elastic member may be disposed about a distal end of the at least one resilient finger.

Where an elastic member is provided that urges the at least one resilient finger towards the cable, the likelihood of the cable being inadvertently removed from the socket is advantageously reduced.

The at least one resilient finger may comprise a groove. The elastic member may be received in the groove.

The groove may be disposed at a distal end of the at least one resilient finger.

The housing may further comprise a detent for holding the locking member in the locked configuration.

Where the housing comprises a detent for holding the locking member in the locked configuration, the likelihood of the locking member inadvertently moving away from the locked configuration is reduced. This advantageously reduces the likelihood of withdrawal of the free second end of the cable from the socket.

The locking member may be moveable between the unlocked configuration and the locked configuration upon exertion of a predetermined load.

When moving between the unlocked configuration and the locked configuration, the locking member may translate along and rotate about the central axis.

Translation along the central axis may allow the locking member to overcome the detent.

The at least one resilient finger may define, in cross-section, a segment of a circle.

The at least one resilient finger may define a linear shape in cross-section. Where the at least one resilient finger comprises a plurality of resilient fingers, and each resilient finger of the plurality of resilient fingers define a linear shape in cross-section, the overall shape defined by the plurality of resilient fingers may be triangular, square, pentagonal, hexagonal, heptagonal, octagonal, or any other suitable shape. The overall shape defined by the plurality of resilient fingers may be understood to refer to a shape that each resilient finger (e.g., an outer or inner periphery of) defines a portion of. Gaps may be present in the overall shape. The gaps may be defined between adjacent fingers.

Where the at least one resilient finger defines, in cross-section, a segment of a circle, the shape of the at least one resilient finger corresponds to the cross-sectional shape of the cable. This advantageously allows the at least one resilient finger to better secure the free second end of the cable within the socket.

The at least one resilient finger may comprise a plurality of resilient fingers.

Where a plurality of resilient fingers are provided, the free second end of the cable can be better secured within the socket, which advantageously reduces the likelihood of the free second end of the cable from being inadvertently withdrawn from the socket in use.

In a second aspect of the invention there is provided a locking member for a measurement sensor. The measurement sensor comprises a housing having at least one finger that defines, at least in part, a socket. The locking member is mountable housing. The locking member is moveable, in use, between an unlocked configuration and a locked configuration in which the locking member limits deformation of the at least one resilient finger.

Features disclosed in relation to one aspect of the invention may be combined with other aspects as appropriate.

### Brief Description of the Drawings

Embodiments of the present invention will now be described with reference to the accompanying drawings, in which:
Figure 1 shows a perspective view of a measurement sensor;
Figure 2 shows a partial view of the measurement sensor of Figure 1; and
Figures 3 and 4 show the measurement sensor with a locking member in an unlocked configuration and in a locked configuration respectively.

### Detailed Description

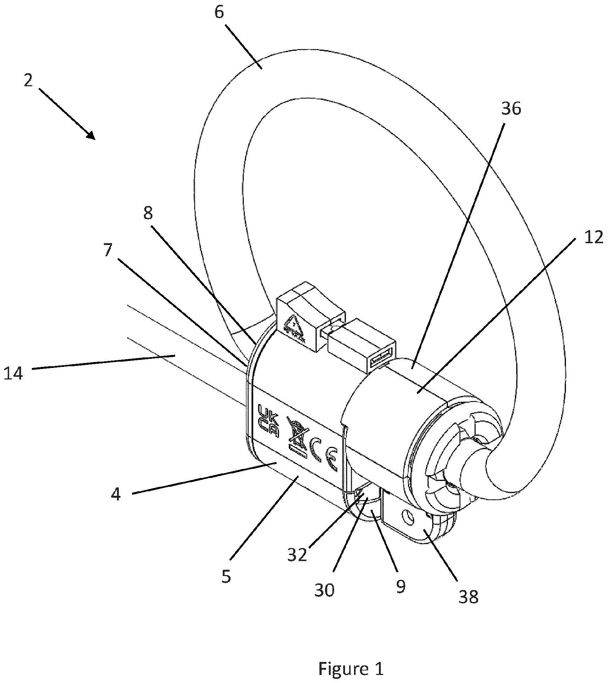

Figure 1 shows a measurement sensor 2. The measurement sensor 2 is for measuring alternating current and/or high speed electrical current pulses. The measurement sensor 2 is a Rogowski coil sensor. However, it will be appreciated that the present teachings are applicable to other types of measurement sensor. The measurement sensor 2 comprises a housing 4. The housing 4 comprises a body 5. The body 5 may be referred to as a main body. The body 5 comprises a first end 7 and a second end 9. The first end 7 is generally opposed to the second end 9. An integrator circuit (not visible - it is within the body 5) is disposed in the housing 4. In particular, the integrator circuit is disposed in the body 5 of the housing 4. However, in other embodiments, the integrator circuit need not be provided.

The measurement sensor 2 further comprises a cable 6. The cable 6 comprises a coil of wire (not visible in Figure 1 - it is disposed within the cable). The cable 6 comprises a first end 8. The cable 6 comprises a second end (not visible in Figure 1 - it is disposed within the housing 4). The second end of the cable 6 is free, and so the second end may be referred to as a free second end. The first end 8 of the cable 6 extends from the housing 4. In particular, the first end 8 of the cable 6 extends from the first end of the housing 4.

The measurement sensor 2 further comprises a locking member 12. The locking member 12 is mounted on to the housing 4. The locking member 12 is moveable between a locked configuration and an unlocked configuration, as will be discussed in more detail below.

The measurement sensor 2 further comprises an output cable 14. The output cable 14 extends from the housing 4. In particular, the output cable 14 extends from the first end of the housing 4. The output cable 14 is connectable to an external device (not shown) to provide readings obtained using the measurement sensor 2 to the external device.

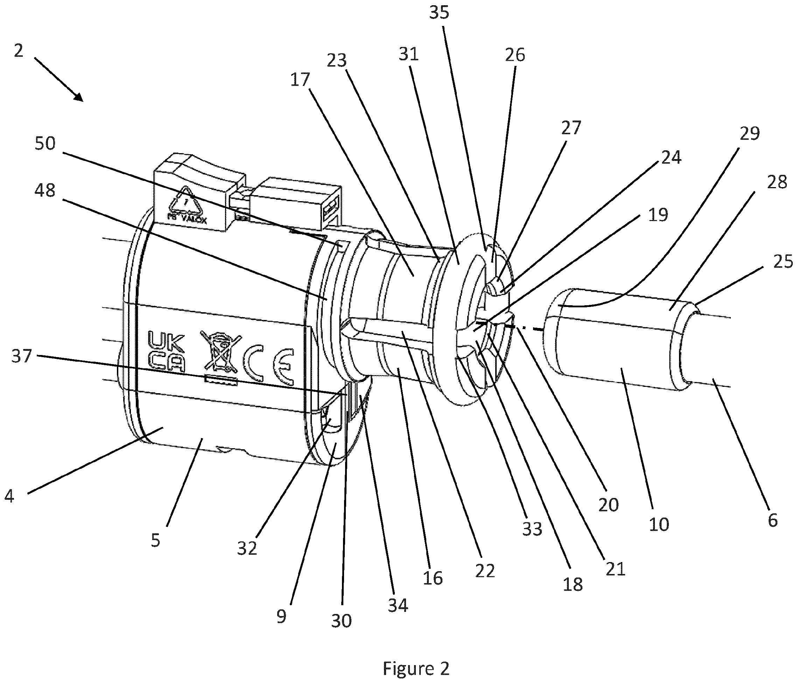

Referring now to Figure 2. In Figure 2, the locking member has been removed to allow more of the housing 4 to be viewed. The housing 4 comprises a plurality of resilient fingers 16 (only one of which has been labelled in Figure 2). The plurality of resilient fingers 16 extend from the second end 9 of the housing 4. The plurality of resilient fingers 16 define a socket 18. The socket 18 defines a central axis 20. The socket 18 is rotationally symmetric. The order of the rotational symmetry of the socket 18 is equal to the number of fingers of the plurality of resilient fingers 16. Therefore, in the depicted embodiment, the order of rotational symmetry of the socket 18 is four. The second end 10 of the cable 6 is receivable by the socket 18. The second end 10 of the cable 6 is releasably retainable by the socket 18. When the second end 10 of the cable 6 is received by the socket 18, the plurality of resilient fingers 16 engage the second end 10 of the cable 6 around end cap 28. This will be discussed in more detail below. Where only one resilient finger 16 is provided, the socket 18 may be defined by the resilient finger 16 and a further portion of the housing 4, which may be in the form of, for example, a U-shaped channel that extends from the second end 9 of the housing 4.

In a cross-section that is perpendicular to the central axis 20 of the socket 18 each finger of the plurality of resilient fingers 16 is generally arc-shaped. In other embodiments, each finger of the plurality of resilient fingers may define any other suitable geometry. Each finger of the plurality of resilient fingers 16 is identical. This advantageously assists with insertion of the second end 10 into the socket. However, in some embodiments, the fingers of the plurality of fingers 16 need not be identical. Each finger of the plurality of resilient fingers 16 defines a radially outer surface 17 (only one of which is labelled in Figure 2). Each finger of the plurality of resilient fingers 16 defines a radially inner surface 19 (only one of which is labelled in Figure 2). In the depicted embodiment, the plurality of resilient fingers 16 comprise four resilient fingers 16. However, in other embodiments, at least one resilient finger need only be provided. In some embodiments, more than four resilient fingers 16 may be provided. For example, in some embodiments, the plurality of resilient fingers 16 may comprise six resilient fingers.

Disposed between adjacent fingers of the plurality of resilient fingers 16 is a respective gap 22. Each gap 22 is disposed circumferentially between adjacent fingers of the plurality of resilient fingers 16. Each gap 22 extends in a direction that is parallel to the central axis 20 of the socket 18.

The radially outer surface 17 of each finger of the plurality of resilient fingers 16 comprises a tapered portion 23. The tapered portion 23 of each finger is disposed adjacent to the distal end 26 of each respective finger. The tapered portion 23 will be discussed in more detail below.

When the second end 10 of the cable 6 is received by the socket 18, the second end of the cable 10 interlocks with the plurality of resilient fingers 16. Each finger of the plurality of resilient fingers 16 comprises a radially inward protrusion 24 (only one of which is labelled in Figure 2). In some, non-depicted, embodiments, not all resilient fingers need comprise a radially inward protrusion. Each radially inward protrusion 24 is disposed at a distal end 26 of the respective finger of the plurality of resilient fingers 16. The term 'distal end' may be understood to refer to an absolute distal end, or to a distal end region of the fingers of the plurality of resilient fingers 16. The second end 10 of the cable 6 comprises a radially outward protrusion 28.

The radially inward protrusions 24 of each finger of the plurality of resilient fingers 16 comprise a first tapered portion 21. The first tapered portion 21 is disposed in the socket 18. The first tapered portion 21 faces towards the housing 4. The radially outward protrusion 28 of the second end 10 of the cable 6 comprises a first tapered portion 25. When the second end 10 of the cable 6 is inserted into the socket 18, the first tapered portion 25 faces away from the housing 4. During removal of the second end 10 of the cable 6 from the socket 18, the first tapered portion 25 of the radially outward protrusion 28 of the second end 10 of the cable 6 engages the first tapered portion 21 of the radially inward protrusions 24 of the plurality of resilient fingers 16. This causes the first tapered portion 21 of the radially inward protrusions 24 of the plurality of resilient fingers 16 to ride up the first tapered portion 25 of the radially outward protrusion 28 of the second end 10 of the cable 6, which urges the plurality of resilient fingers 16 radially outwardly to allow removal of the second end 10 of the cable 6 from the socket 18. The angle of the tapered portions 21, 25 are such that the force required to remove the second end 10 of the cable 6 from the socket is above a predetermined threshold. This advantageously reduces the likelihood of inadvertent removal of the second end 10 of the cable 6 from the socket.

The radially inward protrusions 24 of each finger of the plurality of resilient fingers 16 comprise a second tapered portion 27. The second tapered portion 27 faces away from the housing 4. The radially outward protrusion 28 of the second end 10 of the cable 6 comprises a second tapered portion 29. When the second end 10 of the cable 6 is inserted into the socket 18, the second tapered portion 29 faces towards the housing 4. The second tapered portion 29 of the second end 10 of the cable 6 may be said to be disposed at a distal end of the cable 6. During insertion of the second end 10 of the cable 6 into the socket, the second tapered portion 29 of the second end 10 of the cable 6 engages the second tapered portions 29 of the radially inward protrusions 24 of the plurality of resilient fingers. This causes the second tapered portions 27 of the radially inward protrusions 24 of the plurality of resilient fingers to ride up the second tapered portion 29 of the radially outward protrusion 28 of the second end 10 of the cable 6 to allow easy insertion of the second end 10 of the cable 6 into the socket 18.

When the second end 10 of the cable 6 is received within the socket 18, the radially inward protrusions 24 of the plurality of resilient fingers 16 interlock with the radially outward protrusion 28 of the second end 10 of the cable 6. In particular, the radially inward protrusion 24 of the plurality of resilient fingers 16 radially overlaps with the radially outward protrusion 28 of the second end 10 of the cable 6 when the second end 10 of the cable 6 is received within the socket 18. In particular, the first tapered portion 25 of the radially outward protrusion 28 of the second end 10 of the cable 6 interlocks with the radially inward protrusion 24 of the plurality of resilient fingers 16.

In some, non-depicted, embodiments, the radially inward protrusions 24 of the plurality of resilient fingers 24 may be disposed inboard of (i.e., closer to the body 4) the distal end 26 of the respective finger of the plurality of resilient fingers. In some, non-depicted embodiments, the second end 10 of the cable 6 may comprise a groove that interlocks with the plurality of resilient fingers 16, preferably with the radially inward protrusions 24 of the plurality of resilient fingers 16. Where provided, the groove of the second end 10 of the cable 6 may be disposed along the radially outward protrusion 28 of the second end 10 of the cable 6.

The measurement sensor 2 further comprises an elastic member 31. Each resilient finger of the plurality of resilient fingers 16 comprises a respective groove portion 33.

Together, the groove portions 33 of the plurality of resilient fingers 16 form a groove 35. The groove 35 extends about the distal end 26 of the plurality of resilient fingers 16. The groove 35 extends circumferentially about the distal end 26 of the plurality of resilient fingers 16. Adjacent groove portions 33 are separated by a respective gap of the plurality of gaps 22. The elastic member 31 is at least partly disposed in the groove 35. In some embodiments, the groove 35 need not be provided, and the elastic member 31 may simply be disposed about the distal ends 26 of the fingers of the plurality of resilient fingers 16. In some, non-depicted, embodiments, where the groove 35 is not provided, the plurality of resilient fingers 16 may each comprise a rib. The rib may serve the secure the position of the elastic member 31 with respect to the central axis 20. In some embodiments, the elastic member 31 need not be provided. The elastic member 31 serves to urge the plurality of resilient fingers 16 radially inwards. This increases the force that is required for the fingers of the plurality of resilient fingers 16 to deform radially outwards. This advantageously reduces the likelihood of the second end 10 of the cable being inadvertently withdrawn from the socket 18 in use.

The housing 4 comprises a detent 30. The detent 30 is disposed at the second end 9 of the housing 4. The detent 30 comprises a first protrusion 32 and a second protrusion 34. The first protrusion 32 and the second protrusion 34 extend from the second end 9 of the housing 4 in a direction that is parallel to the central axis 20. The detent 30 comprises a channel 37. The channel 37 is disposed between the first protrusion 32 and the second protrusion 34. The detent 30 cooperates with the locking member (not shown in Figure 2) to retain the locking member in a locked configuration, as will be discussed in more detail below.

Referring back to Figure 1. The locking member 12 comprises a body 36. The body 36 is generally annular. A handle 38 extends from the body 36. The handle 38 extends radially from the body 36. When in the locked configuration, as shown in Figure 1, the handle 38 overlaps with the first protrusion 32 and the second protrusion 34 of the detent 30 in a direction parallel to the central axis (not depicted in Figure 1). In the locked configuration, at least part of the handle 38 is disposed in the channel (not visible in Figure 1 - it is hidden by the handle) of the detent 30.

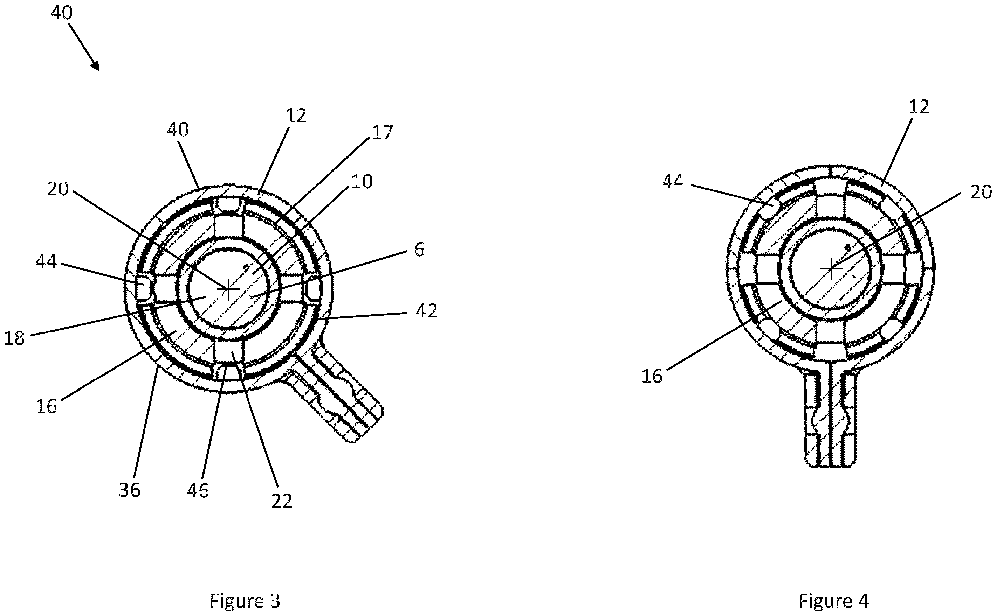

Figure 3 shows the locking member 12 in the unlocked configuration. Figure 3 shows a cross-sectional view taken in a plane that is perpendicular to the central axis 20 and extends through the locking member 12 and the plurality of resilient fingers 16. The body 36 of the locking member 12 comprises a radially outer surface 40. The body 36 of the locking member 12 comprises a radially inner surface 42. The locking member 12 comprises a plurality of radially inward protrusions 44. The plurality of radially inward protrusions 44 extend from the radially inner surface 42 of the body 36 of the locking member 12.

As noted above, the locking member 12 is moveable between a locked configuration and an unlocked configuration. In the unlocked configuration, the locking member 12 permits deformation of the plurality of resilient fingers 16 such that the second end 10 of the cable 6 can be inserted into the socket 18. In the locked configuration, the locking member 12 limits deformation of the plurality of resilient fingers 16 to retain the second end 10 of the cable 6 in the socket. Figure 3 shows the locking member 12 in the unlocked configuration. In the unlocked configuration each protrusion of the plurality of radially inward protrusions 44 are disposed adjacent to a respective gap 22. In particular, each protrusion of the plurality of radially inward protrusions 44 are disposed radially adjacent a respective gap 22. In the unlocked configuration, the locking member 12 permits radially outward deformation of the plurality of resilient fingers 16 such that the second end 10 of the cable 6 can be inserted into the socket 18.

Each protrusion of the plurality of radially inward protrusions 44 defines a radially inner surface 46. In the unlocked configuration, the radial distance from the central axis 20 to the radially outer surface 17 of each finger of the plurality of resilient fingers 16 is greater than or equal to the radial distance from the central axis 20 to the radially inner surface 46 of each of the plurality of inward protrusions 44.

Figure 4 shows the locking member 12 in the locked configuration. In the locked configuration, each protrusion of the plurality of radially inward protrusions 44 are disposed radially outboard of, and engage, a respective finger of the plurality of resilient figures 16. This limits deformation of the plurality of resilient fingers 16, to maintain the interlock between the second end 16 of the cable 10 such that the second end 16 of the cable 10 is retained within the socket 18. In some embodiments, the plurality of radially inward protrusions 44 need not engage the plurality of fingers 16 in the locked configuration.

Referring again to Figure 2, the housing 4 comprises a groove 48. The groove 48 is disposed adjacent to the second end 9 of the body 5 of the housing 4. The groove 48 extends about the central axis 20. The groove 48 comprises a first end face 50 and a second end face (not visible in Figure 2 - it is located on the side of the housing 4 that is out of view). When the locking member is mounted onto the housing 4, a corresponding protrusion of the locking member is received in the groove. In some embodiments, the locking member may comprise two protrusions. When the locking member is rotated from the locked configuration to the unlocked configuration, the protrusion engages the first end face 50 or the second end face of the groove 48 to limit rotation of the locking member. Where the locking member comprises two protrusions, a first protrusion may engage the first end face 50 when the locking member is rotated in a first direction and a second protrusion may engage the second end face when the locking member is rotated in a second direction. The position of the locking member when the relevant protrusion engages the first end face 50 or the second end face of the groove 48 corresponds to the locking member being in the unlocked configuration. That is to say, the position of the locking member when the relevant protrusion engages the first end face 50 or the second end face of the groove 48 corresponds to each protrusion of the plurality of radially inward protrusions 44 is disposed adjacent to a respective gap 22. The makes operation of the device simpler because the user can more readily determine the unlocked configuration. In some embodiments, the locking member may comprise a groove and the body 5 of the housing 4 may comprise one or more protrusions.

To use the device, the cable 6 is passed about a conductor to be sensed such that the cable extends around the conductor. With the locking member 12 in the unlocked configuration, the second end 10 of the cable 6 is then inserted into the socket 18. During insertion, the second tapered portion 29 of the second end 10 of the cable 6 engages the second tapered portion 27 of the fingers of the plurality of resilient fingers 16. This urges the plurality of resilient fingers 17 radially outwardly. The second end 10 of the cable 6 is inserted into the socket 18 until the plurality of resilient fingers 16 interlock with the second end 10 of the cable 6, as described above.

The locking member 12 is then rotated from the unlocked configuration to the locked configuration. As the locking member 12 is rotated from the unlocked configuration to the locked configuration, the handle 38 of the locking member 12 rides over the first protrusion 32 or the second protrusion 34. This urges the locking member 12 in a direction that is parallel to the central axis 20. Therefore, the locking member 12 may said to translate along and rotate about the central axis 20 when moving from the unlocked configuration and the locked configuration (and vice versa). As the locking member 12 is urged in the direction that is parallel to the central axis 20, the locking member engages the tapered surface 23 of each finger of the plurality of resilient fingers 16. Once the locking member 12 reaches the locked configuration, and the handle 38 is disposed in the channel 37 of the detent 30, the tapered surfaces 23 of the plurality of resilient fingers urge the locking member in a direction that is parallel to the central axis 20 and towards the housing 4. This helps to retain the handle 38 in the channel 37. The locking member 12 may be moved from the unlocked configuration to the locked configuration (and vice versa) upon exertion of a predetermined load.

To remove the second end 10 of the cable 6 from the socket 18, the locking member 12 is returned to the unlocked configuration by rotating the locking member 12. The cable 6 is then be pulled by a user, which deforms the plurality of resilient fingers 16 to allow the second end 10 of the cable 6 to be withdrawn from the socket 18. During removal of the second end 10 of the cable 6 from the socket, the first tapered portion 25 of the radially outward protrusion 28 of the second end 10 of the cable 6 engages the first tapered portion 21 of the radially inward protrusion 24 of the fingers of the plurality of resilient fingers 16.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A measurement sensor comprising:
a housing; and
a cable having a first end that extends from the housing and a free second end;
wherein the housing comprises at least one resilient finger, and a socket that is defined, at least in part, by the at least one resilient finger, wherein the socket defines a central axis;
wherein the free second end of the cable is receivable by the socket such that the at least one resilient finger engages the free second end of the cable to releasably retain the free second end of the cable within the socket;
wherein the measurement sensor further comprises a locking member that is mounted to the housing, the locking member being moveable between an unlocked configuration and a locked configuration in which the locking member limits deformation of the at least one resilient finger.

2. The measurement sensor of claim 1, wherein the locking member comprises at least one radially inward protrusion that limits radially outward deformation of the at least one resilient finger when the locking member is in the locked configuration.

3. The measurement sensor of claim 2, wherein, in the unlocked configuration, a radial distance from the central axis to a radially outer surface of the at least one finger is greater than or equal to a radial distance from the central axis to a radially inner surface of the at least one protrusion.

4. The measurement sensor of any preceding claim, wherein, the free second end of the cable is receivable by the socket such that the at least one resilient finger interlocks with the free second end of the cable.

5. The measurement sensor of any preceding claim, wherein the at least one resilient finger comprises a radially inward protrusion and the free second end of the wire comprises a radially outward protrusion, wherein the radially inward protrusion interlocks with the radially outward protrusion when the free second end of the cable is received by the socket.

6. The measurement sensor of claim 5, wherein the radially inward protrusion is disposed at a distal end of the at least one resilient finger.

7. The measurement sensor of any preceding claim, wherein, with the locking member in the unlocked configuration, during insertion of the free second end of the cable, the at least one resilient finger is configured to deform radially outwardly.

8. The measurement sensor of any preceding claim, further comprising an elastic member that is disposed about the at least one resilient finger, the elastic member being configured to urge the at least one resilient finger radially inwards.

9. The measurement sensor of claim 8, wherein the at least one resilient finger comprises a groove, and wherein the elastic member is received in the groove.

10. The measurement sensor of any preceding claim, wherein the housing further comprises a detent for holding the locking member in the locked configuration.

11. The measurement sensor of claim 10, wherein the locking member is moveable between the unlocked configuration and the locked configuration upon exertion of a predetermined load.

12. The measurement sensor of claim 10 or claim 11, wherein, when moving between the unlocked configuration and the locked configuration, the locking member translates along and rotates about the central axis.

13. The measurement sensor of any preceding claim, wherein the at least one resilient finger defines, in cross-section, a segment of a circle.

14. The measurement sensor of any preceding claim, wherein the at least one resilient finger comprises a plurality of resilient fingers.

15. A locking member for a measurement sensor, the measurement sensor comprising a housing having at least one finger that defines, at least in part, a socket, the locking member being mountable to the housing and being moveable, in use, between an unlocked configuration and a locked configuration in which the locking member limits deformation of the at least one resilient finger.
